(19) Europäisches Patentamt
European Patent Office
Office européen des brevets

(11) **EP 1 142 004 B1**

(12) **EUROPÄISCHE PATENTSCHRIFT**

(45) Veröffentlichungstag und Bekanntmachung des Hinweises auf die Patenterteilung:
**13.10.2004 Patentblatt 2004/42**

(51) Int Cl.[7]: **H01L 21/00**, C30B 31/06, C23C 16/46

(21) Anmeldenummer: **99968308.9**

(22) Anmeldetag: **16.12.1999**

(86) Internationale Anmeldenummer:
**PCT/DE1999/004035**

(87) Internationale Veröffentlichungsnummer:
**WO 2000/039840 (06.07.2000 Gazette 2000/27)**

(54) **VERFAHREN ZUR BOR-DOTIERUNG VON WAFERN UNTER EINSATZ EINES VERTIKALOFENSYSTEMS**

METHOD FOR BORON DOPING WAFERS USING A VERTICAL OVEN SYSTEM

PROCEDE DE DOPAGE AU BORE DE TRANCHES, MIS EN OEUVRE A L'AIDE D'UN SYSTEME DE FOUR VERTICAL

(84) Benannte Vertragsstaaten:
**AT FR GB IE IT**

(30) Priorität: **17.12.1998 DE 19858351**
**10.11.1999 DE 19954021**

(43) Veröffentlichungstag der Anmeldung:
**10.10.2001 Patentblatt 2001/41**

(73) Patentinhaber: **Vishay Semiconductor Itzehoe GmbH**
**25524 Itzehoe (DE)**

(72) Erfinder:
- **BONESS, Henning**
  **D-25524 Itzehoe (DE)**
- **PRESS, Patrick**
  **D-24105 Kiel (DE)**

(74) Vertreter: **Gagel, Roland, Dr.**
**Patentanwalt Dr. Roland Gagel,**
**Landsberger Strasse 480a**
**81241 München (DE)**

(56) Entgegenhaltungen:
**EP-A- 0 438 677        EP-A- 0 538 874**
**EP-A- 0 736 614        US-A- 5 217 560**

- **P. C. PAREKH AND D. R. GOLDSTEIN: "The Influence of Reaction Kinetics Between BBr3 and O2 on the Uniformity of Base Diffusion" PROCEEDING OF THE IEEE, Bd. 57, Nr. 9, September 1969 (1969-09), Seiten 1507-1512, XP000892051 USA in der Anmeldung erwähnt**

**Beschreibung**

**Technisches Gebiet**

Die vorliegende Erfindung betrifft ein Verfahren zur Bor-Dotierung von Wafern unter Einsatz eines Vertikalofensystems. Die Bor-Dotierung von Wafern, insbesondere Siliziumwafern, spielt in der Halbleitertechnik eine große Rolle. Das vorliegende Verfahren kann hierbei insbesondere bei der Fertigung von Halbleiterprodukten wie Power MOSFETs in DMOS-Technologie oder Bipolartransistoren eingesetzt werden.

**Stand der Technik**

Für die Bor-Dotierung von Siliziumwafern sind bislang zwei unterschiedliche Techniken technisch relevant. Eine Technik betrifft die direkte Implantation von Bor in die Siliziumwafer, die andere Technik setzt Quellschichten zur Diffusion des Bors in die Siliziumwafer ein.

Das erstgenannte Verfahren der Implantation von Bor, bei dem Bor-Ionen beschleunigt werden und mit hoher Geschwindigkeit auf die Siliziumwafer auftreffen, verursacht jedoch aufgrund der bei bestimmten Anwendungen erforderlichen hohen Implantationsdosis sehr hohe Prozesskosten. Weiterhin lässt sich dieses Verfahren nur als Einzelwaferprozess durchführen, wodurch sich der Zeitaufwand und somit wiederum die Prozesskosten erhöhen. Ein weiterer Nachteil dieser Technik besteht darin, dass das durch Implantation erzeugte Profil der Borkonzentration im Siliziumwafer nicht kastenförmig sondern gaußförmig ist. Soll mit dieser Technik ein Erfc-Profil erreicht werden, so erfordert dies eine zweite Implantation. Gerade kastenförmige Dotierungsprofile werden jedoch für die oben genannten Power MOSFETs und Bipolartransistoren benötigt.

Für die Herstellung derartiger Dotierungsprofile zu vertretbaren Kosten, wird daher in der Regel das zweitgenannte Dotierungsverfahren unter Benutzung von Quellschichten eingesetzt. Bei diesem Verfahren erfolgt die Bor-Dotierung aus einer aus dem Wafer abgeschiedenen Festkörperschicht. Das Dotierungsverfahren erfordert einen zweistufigen Prozess. In einer ersten Stufe wird eine dünne, hochkonzentrierte Bor-Schicht durch Niedertemperatur-Abscheidung auf der Waferoberfläche erzeugt. Aus dieser dünnen Bor-Schicht diffundiert das Bor in einer zweiten Stufe durch einen Hochtemperatur-Diffusionsprozess in die Oberfläche der Wafer bis zur gewünschten Tiefe ein.

Durch die ständig steigende Größe der Wafer und das Erfordernis, eine möglichst große Anzahl von Wafern in einem Prozessdurchlauf zu dotieren, tritt die Problematik der Gleichförmigkeit der erzeugten Dotierung und der Reproduzierbarkeit dieser Dotierung zwischen einzelnen Prozessdurchläufen in den Vordergrund. So muss einerseits gewährleistet werden, dass das gewünschte Dotierungsprofil auf dem einzelnen Wafer möglichst gleichförmig ausgebildet ist, zum anderen muss die Abweichung im Dotierungsprofil bzw. der Dotierungskonzentration zwischen einzelnen Wafern eines Prozessdurchlaufes wie auch zwischen Wafern unterschiedlicher Prozessdurchläufe vernachlässigbar klein sein.

Eine Verfahrensvariante zur Bor-Dotierung von Siliziumwafern aus einer Festkörperschicht setzt Bor-Nitridwafer als Bor-Quelle zur Erzeugung der Quellschicht auf den Siliziumwafern ein. Ein derartiges Verfahren ist beispielsweise aus J. Monkowski et al., Solid State Technology, November 1976, Seiten 38 bis 42 bekannt. Bei diesem Verfahren wird ein Horizontalofensystem eingesetzt, bei dem die einzelnen Wafer im so genannten Quarzboot hintereinander aufgestellt sind. Die Bor-Nitridwafer sind hierbei zwischen den einzelnen Siliziumwafern angeordnet.

Dieses Verfahren hat jedoch den Nachteil, dass sich durch die notwendige Anordnung der Bor-Nitridwafer die Ofenkapazität für die eigentlich zu dotierenden Siliziumwafer um 50% reduziert. Weiterhin besteht die Gefahr, dass die Quarzware der Prozesskammer durch Verkleben der Bor-Nitridwafer mit dem Quarzboot verunreinigt bzw. beschädigt wird. Ein weiterer Nachteil besteht in der aufwendigen Lagerung und Konditionierung der Bor-Nitridwafer, die zudem einen hohen Preis und nur eine begrenzte Haltbarkeit haben.

Ein weiteres Verfahren zur Bor-Dotierung von Siliziumwafern aus einer Festkörperschicht ist aus P.C. Parekh et al., Proceedings of the IEEE, Vol. 57, Number 9, September 1969, Seiten 1507 bis 1512 bekannt. Bei diesem Verfahren wird flüssiges $BBr_3$ (Bortribromid) als Quelle eingesetzt. Hierzu werden Sauerstoff und $BBr_3$ zusammen mit Stickstoff als Transportgas in den Reaktionsraum mit den Wafern eingeleitet. Im Reaktionsraum bildet $BBr_3$ mit dem Sauerstoff das so genannte Reaktivgas, das folgendermaßen reagiert:

$$2\, BBr_3\ (g) + 3/2\ O_2\ (g) \rightarrow B_2O_3 + 3\ Br_2\ (g)$$

$$2\, B_2O_3 + 3\ Si \rightarrow 4\ B^+ + 3\ SiO_2\ (Borglas)$$

Das Borglas wird hierdurch auf der Oberfläche der Wafer abgeschieden. Das so entstandene Borglas dient als Quellschicht, aus der während der nachfolgenden Diffusionsphase (Drive-In) Bor in das darunter befindliche Wafersubstrat diffundiert. Bei diesem Verfahren wurde ein Horizontalofensystem mit einer ausgedehnten Zone konstanter Temperatur eingesetzt. Die Abscheidung des Borglases erfolgte bei einer Temperatur im Bereich zwischen 860 und 950°C, die Diffusion bei 1220°C. Auch hierbei stand das Problem der Gleichförmigkeit der Dotierung im Vordergrund.

Ein Nachteil des dargestellten Verfahrens besteht darin, dass auch hier die Gleichförmigkeit der Dotierung, insbesondere über die Länge des eingesetzten Horizontalofens, nicht eingehalten werden konnte.

Weiterhin lassen sich bei Einsatz eines Horizontalofensystems nicht ohne weiteres größere Waferdurchmesser prozessieren. So werden derzeit maximal Waferdurchmesser von 5 Zoll (1 Zoll = 2.54 cm) in Horizontalofensystemen dotiert. Eine Konversion von 5 auf 6 Zoll-Wafer ist aufgrund der hierfür notwendigen Änderungen der Prozessspezifikationen hinsichtlich der Gleichförmigkeit der Dotierung auf dem Siliziumwafer nur unter erheblichem Aufwand möglich.

Ausgehend von diesem Stand der Technik liegt der Erfindung die Aufgabe zugrunde, ein Verfahren zur Bor-Dotierung von Wafern anzugeben, mit dem eine hohe Gleichförmigkeit der Dotierung erreicht werden kann, und dass ohne konstruktive Änderungen bestehender Ofensysteme einen Übergang von kleineren zu größeren Waferdurchmessern ermöglicht. Das Verfahren soll weiterhin kostengünstig durchführbar sein.

## Darstellung der Erfindung

Die Aufgabe wird mit dem Verfahren nach Anspruch 1 gelöst. Vorteilhafte Ausgestaltungen des Verfahrens sind Gegenstand der Unteransprüche.

Bei dem erfindungsgemäßen Verfahren zur Bor-Dotierung von Wafern wird ein vertikaler Diffusionsofen eingesetzt, der einen sich von einem oberen Ende zu einem unteren Ende vertikal erstreckenden Reaktionsraum mit mehreren unabhängig voneinander heizbaren Temperaturzonen aufweist. Am oberen Ende des Reaktionsraumes befindet sich ein Gaseinlass für ein borhaltiges Reaktivgas. Die einzelnen Temperaturzonen erstrecken sich nacheinander vom oberen Ende zum unteren Ende des Reaktionsraumes. Bei dem erfindungsgemäßen Verfahren wird das borhaltige Reaktivgas über die im Reaktionsraum an geordneten Wafer geleitet, um dort eine Borschicht, insbesondere Borglas, abzuscheiden. Anschließend wird das Bor aus der Borschicht in die Oberfläche der Wafer eindiffundiert. Erfindungsgemäß wird die Temperatur der unabhängig voneinander heizbaren Temperaturzonen so eingestellt, dass zwischen der sich an die oberste Temperaturzone anschließenden Zone und der untersten Temperaturzone während der Abscheidung der Borschicht ein Temperaturanstieg und während der anschließenden Diffusion ein Temperaturabfall aufrechterhalten werden.

Diese weiteren Temperaturzonen erstrecken sich im Reaktionsraum des Vertikalofens über den Bereich, der mit Wafern befüllt ist. Die oberste Zone deckt den Bereich für den Gaseinlass ab. Der Temperaturanstieg bzw. Temperaturabfall zum unteren Ende des Reaktionsraumes hin wird durch stufenweise Steigerung oder Verminderung der Temperatur von Zone zu Zone herbeigeführt. Sehr gute Ergebnisse lassen sich hierbei mit einem vertikalen Diffusionsofen realisieren, der in fünf Temperaturzonen unterteilt ist, wobei die mittlere Temperaturzone etwa die Hälfte der Höhe des Reaktionsraumes einnimmt. Das borhaltige Reaktivgas kann durch unterschiedliche flüssige oder gasförmige Bor-Quellen bereitgestellt werden. Beispiele hierfür sind Quellen aus $BBr_3$, $BCl_3$ oder $B_2H_6$.

Das erfindungsgemäße Verfahren unterscheidet sich von den einleitend genannten Verfahren einerseits durch den Einsatz eines Vertikalofens und andererseits durch die Aufrechterhaltung unterschiedlicher Temperaturzonen mit unterschiedlichen Temperaturen während des Abscheide- und Diffusionsprozesses.

Mit dem erfindungsgemäßen Verfahren unter Einsatz des Vertikalofensystems gelingt der Transfer eines Bordotierungsprozesses von Silizium-Waferdurchmessern mit maximal 5 Zoll, wie beim aufgezeigten Stand der Technik, auf 6 Zoll ohne die Notwendigkeit aufwendiger Umbauten am Diffusionsofen. Mit dem Verfahren lässt sich insbesondere eine gegenüber den einleitend genannten Verfahren verbesserte Gleichförmigkeit der Dotierung erzielen. Dies betrifft sowohl die Gleichmäßigkeit des Schichtwiderstandes über den Wafer wie auch über den gesamten Reaktionsraum bzw. die Länge des eingesetzten Quarzbootes. Ebenso lassen sich die Ergebnisse von Prozessdurchlauf zu Prozessdurchlauf hervorragend reproduzieren.

Das erfindungsgemäße Verfahren vermeidet den Einsatz und den Unterhalt von teuren Bornitrid-Quellwafern. Das Verfahren ermöglicht die Dotierung eines Silizium-Substrates mit Bor einer hohen Konzentration von über $1 \times 10^{19}$ $cm^{-3}$ an der Waferoberfläche. Das Konzentrationsprofil des Dotanten ist dabei kastenförmig und wird näherungsweise durch eine Erfc-Funktion beschrieben. Dadurch steht für die speziellen Anforderungen von Power MOS und Bipolar-Halbleiterprozessen hinsichtlich der Form des Borkonzentrationsprofils ein stabiler und wirtschaftlicher Dotierungsprozess zur Verfügung.

Vorzugsweise werden die Temperaturen während der Abscheidung der Borschicht aus dem Temperaturbereich zwischen 800°C und 950°C und während der Diffusion aus dem Temperaturbereich zwischen 1020°C und 1050°C gewählt. Ein gutes Ergebnis ergibt sich insbesondere dann, wenn die Temperatur in der obersten Zone sowohl während der Abscheidung als auch während der Diffusion höher gewählt ist, als die Temperatur der jeweils sich anschließenden Temperaturzone. Diese Temperatur der obersten Temperaturzone beeinflusst die Temperatur des durch den Gaseinlass einströmenden Reaktivgases. Das Reaktivgas wird vorzugsweise über eine BBr$_3$-Flasche (BBr$_3$-Bubbler) durch Vermischung mit Sauerstoff bereitgestellt.

Hervorragende Ergebnisse lassen sich mit dem erfindungsgemäßen Verfahren bei Einsatz eines vertikalen Diffusionsofens mit zumindest fünf Temperaturzonen erreichen, wenn während der Abscheidung der Borschicht die Temperaturen von der obersten bis zur untersten Zone auf 860°C, 845°C, 860°C, 890°C und 900°C - jeweils mit einer Genauigkeit von ±5°C - eingestellt werden, und während der Diffusion auf 1042°C, 1037°C, 1035°C, 1027,5°C und 1025°C - jeweils mit einer Genauigkeit von ±0,5°C - eingestellt werden. Diese Temperatureinstellung ergibt eine sehr hohe Gleichförmigkeit der eingebrachten Dotierungsprofile.

Bei Einsatz einer Mischung aus Sauerstoff und BBr$_3$ als Reaktivgas und Stickstoff als Transportgas lassen sich besonders vorteilhafte Ergebnisse - bei einem Volumen des Reaktionsraumes 50 ± 5 Liter - mit Gasflüssen von 10 slm ± 0,5 slm für das Transportgas, von 0,1 slm ± 0,01 slm für den Sauerstoff und von 0,1 slm ± 0,01 slm für das BBr$_3$ erzielen. Der Fachmann ist in der Lage diese Werte auf einen Reaktionsraum mit anderem Volumen anzupassen.

## Wege zur Ausführung der Erfindung

Die Erfindung wird nachfolgend anhand eines Ausführungsbeispiels in Verbindung mit der Zeichnung ohne Beschränkung des allgemeinen Erfindungsgedankens nochmals beispielhaft erläutert.

Die einzige Figur zeigt hierbei schematisch den Aufbau eines vertikalen Diffusionsofens 1 mit einem sich vertikal erstreckenden Reaktionsraum 2. In dem Reaktionsraum 2 befindet sich das Quarzboot 3 mit den Wafern, von denen hier zur Veranschaulichung beispielhaft nur ein Wafer 4 dargestellt ist. Am oberen Ende des Reaktionsraumes 2 befindet sich der Gaseinlass 6 für das Reaktivgas. Am unteren Ende ist ein Gasauslass 8 für die durchströmenden Gase vorgesehen. Bezugszeichen 7 bezeichnet ein 5-teiliges Thermoelement, mit dem die Temperaturen in 5 Temperaturzonen während des Prozesses erfaßt werden können. In der Figur sind diese fünf Temperaturzonen 5a bis 5e zu erkennen. Die oberste Temperaturzone 5a beeinflusst im Wesentlichen den Gaseinlass 6 für das Reaktivgas, während die weiteren Temperaturzonen 5b bis 5e den Bereich abdecken, in dem die Wafer 4 angeordnet sind. Ein derartiger Vertikalofen ist kommerziell erhältlich.

Im Folgenden sollen Siliziumwafer mit einem kastenförmigen Borkonzentrationsprofil und einer Oberflächenkonzentration von > 3 X 10$^{19}$ cm$^{-3}$ versehen werden. Der Zielschichtwiderstand soll bei 20,5 Ohm/Square liegen. Dieser ist im Bereich von 17,5 - 23,5 Ohm/Sq einstellbar. Die Variation des Schichtwiderstandes soll hierbei über den Wafer bei maximal 2 Ohm/Sq, über das Boot bei maximal 1 Ohm/Sq und von Fahrt zu Fahrt bei maximal 1 Ohm/Sq liegen. Die Tiefe des p/n-Übergangs soll 0,9 μm betragen.

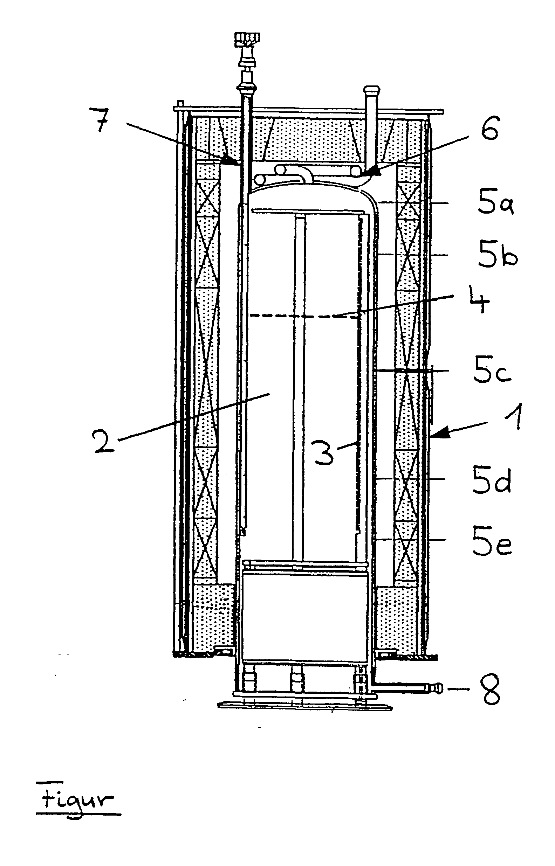

Zum Erreichen dieser Vorgaben wird das in Figur 1 dargestellte Vertikalofensystem 1 mit den fünf unabhängig heizbaren Temperaturzonen 5a bis 5e ohne weitere Modifikationen am Gaseinlass 6 oder an anderen Teilen eingesetzt. Für die Bereitstellung des Reaktivgases wird ein BBr$_3$-Bubbler, der in der Figur nicht dargestellt ist, verwendet. Der Reaktionsraum 2 dieses Ofens hat ein Volumen von ca. 50 Litern.

Zur Realisierung der Vorgaben wurden die Gasflüsse der Gase Stickstoff (N$_2$-Carrier), Sauerstoff (O$_2$ und BBr$_3$) sowie die Temperatur der einzelnen Heizzonen während der Deposition und der Diffusion innerhalb des durch die Randbedingungen definieren Parameterraumes eingestellt.

Bei dem Prozess werden bei ca. 900°C Sauerstoff und BBr$_3$ zusammen mit Stickstoff als Transportgas in den Reaktionsraum 2 geleitet. Da BBr$_3$ bei Raumtemperatur in flüssiger Form vorliegt, wird im vorliegenden Beispiel das so genannte Bubbler-Prinzip zur Einbringung der Chemikalie in den Reaktionsraum genutzt. Hierbei wird Stickstoff durch ein Quarzgefäß geleitet, das mit flüssigem BBr$_3$ gefüllt ist. Der Stickstoff reißt BBr$_3$-Flüssigkeit mit sich bis in den Reaktionsraum 2. Die Aufgabe des Transportgases ist es, im gesamten Reaktionsraum eine möglichst gleichmäßige Menge an Reaktivgasen, das heißt im vorliegenden Fall Sauerstoff und BBr$_3$, zur Verfügung zu stellen. Durch die in der Beschreibungseinleitung aufgezeigte Reaktion der beiden Gase scheidet sich Borglas als Quellschicht auf den im Reaktionsraum 2 befindlichen Wafern 4 nieder.

Die zum Erreichen der Vorgaben eingestellten Parameter betragen hinsichtlich des Gasflusses (gemessen in slm = Liter/Minute unter Standardbedingungen):

- N$_2$-Carrier: 10 slm ± 0,5 slm
- O$_2$: 0,1 slm ± 0,01 slm
- BBr$_3$: 0,1 slm ± 0,01 slm.

Während der Deposition wurde die Temperatur der Heizzonen mit einer Genauigkeit von ± 5°C folgendermaßen eingestellt:

- Zone 1 (5a; am Gaseinlass): 860°C

- Zone 2 (5b): 845°C
- Zone 3 (5c): 860°C
- Zone 4 (5d): 890°C
- Zone 5 (5e): 900°C

Die Depositionszeit betrug 45 Minuten.

Nach Abscheidung der Borglasschicht unter Beachtung der oben genannten Prozessparameter diffundiert das Bor aus dieser Schicht in Abhängigkeit von Zeit und Temperatur in das darunter befindliche Siliziumsubstrat. Je nach Zeit und Temperatur stellt sich hierbei ein bestimmtes Konzentrationsprofil ein, aus dem sich wiederum ein bestimmter Schichtwiderstandswert ergibt. Da das deponierte Borglas eine so genannte "unendliche" Quelle darstellt, ergibt sich ein kastenförmiges Borkonzentrationsprofil. Zur Erreichung der für dieses Beispiel herangezogenen Vorgaben, wird die Temperatur der Heizzonen während des Drive-In mit einer Genaüigkeit von ± 0,5°C folgendermaßen eingestellt:

- Zone 1 (5a; am Gaseinlass): 1042°C
- Zone 2 (5b): 1037°C
- Zone 3 (5c): 1035°C
- Zone 4 (5d): 1027,5°C
- Zone 5 (5e): 1025°C

Nach diesem Diffusionsprozess wird das Borglas von der Oberfläche der Wafer abgeätzt, so dass für die Folgeprozesse ein bordotierter Siliziumwafer mit den genannten Vorgaben zur Verfügung steht.

Bei diesem Beispiel wurden 6 Zoll Siliziumwafer eingesetzt. Das Quarzboot 3 im Reaktionsraum 2 wurde mit einer vollen Beladung von 125 Wafern 4 bestückt, von denen 3 als Testwafer dienten. Diese befanden sich in den Positionen 110, 65 und 11. Position 125 befindet sich nächstgelegend zum Gaseinlass 6. Nach Durchlaufen des Prozesses wurde das Borglas von den Testwafern mit Flusssäure (HF) entfernt. Anschließend wurde der Schichtwiderstand der Testwafer auf einem kommerziellen Messgerät mittels eines 4-Punkt-Messverfahrens an insgesamt 115 Positionen über den Wafer verteilt bestimmt. Es ergaben sich die folgenden Werte:

| waferposition | Schichtwiderstand [Ohm/Square] | | |
|---|---|---|---|
| | Minimum | Maximum | Differenz über Wafer |
| 110 | 19,2 | 20,5 | 1,4 |
| 65 | 19,8 | 20,9 | 1,3 |
| 11 | 19,7 | 20,7 | 1,0 |

Aus diesen Werten ergibt sich für die Gleichförmigkeit über den Wafer eine Variation des Schichtwiderstandes von maximal 1,4 Ohm/Sq, für den Schichtwiderstand über das Boot eine Variation von maximal 0,14 Ohm/Sq. Weitere Prozessdurchläufe mit der selben Versuchsanordnung unter den gleichen Parametern ergaben eine Gleichförmigkeit des Schichtwiderstandes von Fahrt zu Fahrt von besser als 0,5 Ohm/Sq. Die Form des Borkonzentrationsprofils sowie die erreichte Tiefe des p/n-Überganges wurden mittels der Spreading Resistance Technik auf einem kommerziellen Messgerät bestimmt. Für die Tiefe des Überganges ergab sich ein Wert von 0,9 μm. Die Oberflächenkonzentration betrug ca. $6 \times 10^{19}$ cm$^{-3}$ und liegt somit im geforderten Bereich. Aus diesen Messwerten ist ersichtlich, dass die Vorgaben mit dem Einsatz des erfindungsgemäßen Verfahrens hervorragend eingehalten werden konnten.

Mit dem erfindungsgemäßen Verfahren gelingt es, innerhalb des Reaktionsraumes eine gemäß den Vorgaben gleichmäßige Abscheidung über die einzelnen Wafer sowie von Fahrt zu Fahrt zu erreichen. Das Verfahren ermöglicht die Durchführung als Batch-Prozess bei voller Ausnutzung der ofenspezifischen Beladungskapazität. Das Verfahren erfordert keine Quellwafer und kommt mit geringem Chemikalienverbrauch aus, so dass die Bordotierung sehr wirtschaftlich durchgeführt werden kann. Durch den Einsatz des Vertikalofensystems bieten sich uneingeschränkte Möglichkeiten für automatisches Handling, das heißt insbesondere für die Beladung und Entladung der Siliziumwafer mittels Roboter ohne spezielle Waferkippfähigkeiten der eingesetzten Roboter. Insgesamt kann ein kostengünstiges Verfahren bereitgestellt werden, das einen problemlosen Übergang von 5 Zoll- auf 6 Zoll-Wafer und eine sehr hohe Gleichförmigkeit und Reproduzierbarkeit des Dotierungsprofils ermöglicht.

# EP 1 142 004 B1

Bezugszeichenliste

| | |
|---|---|
| 1 | Vertikalofen |
| 2 | Reaktionsraum |
| 3 | Quarzboot |
| 4 | Wafer |
| 5a | erste bzw. obere Heizzone |
| 5b | zweite Heizzone |
| 5c | dritte Heizzone |
| 5d | vierte Heizzone |
| 5e | fünfte Heizzone |
| 6 | Gaseinlass 1 |
| 7 | Thermoelement |
| 8 | Gasauslass |

**Patentansprüche**

1.  Verfahren zur Bor-Dotierung von Wafern unter Einsatz eines Vertikalofensystems (1), das einen sich von einem oberen Ende zu einem unteren Ende vertikal erstreckenden Reaktionsraum (2) mit mehreren unabhängig voneinander heizbaren Temperaturzonen (5a-e) aufweist, von denen eine obere Zone (5a) an einem Gaseinlass (6) für ein borhaltiges Reaktivgas vorgesehen ist und sich die weiteren Zonen (5b-e) bis zum unteren Ende des Reaktionsraumes anschließen,
    bei dem das borhaltige Reaktivgas über im Reaktionsraum (2) befindliche Wafer (4) geleitet wird, um auf den Wafern (4) eine Borschicht abzuscheiden, und anschließend Bor durch Diffusion aus der Borschicht in die Oberfläche der Wafer (4) eindringt,
    wobei die Temperatur der weiteren Zonen (5b-e) so eingestellt wird, dass während der Abscheidung der Borschicht über den weiteren Zonen ein Temperaturanstieg und während der Diffusion über den weiteren Zonen ein Temperaturabfall zum unteren Ende des Reaktionsraumes (2) hin aufrechterhalten werden.

2.  Verfahren nach Anspruch 1,
    **dadurch gekennzeichnet,**
    **dass** die Temperatur der weiteren Zonen (5b-e) während der Abscheidung der Borschicht aus dem Temperaturbereich zwischen 800°C und 950°C und während der Diffusion aus dem Temperaturbereich zwischen 1020°C und 1050°C gewählt wird.

3.  Verfahren nach Anspruch 1 oder 2,
    **dadurch gekennzeichnet,**
    **dass** in der oberen Zone (5a) sowohl während der Abscheidung als auch während der Diffusion eine höhere Temperatur als in der sich anschließenden (5b) der weiteren Zonen eingestellt wird.

4.  Verfahren nach einem der Ansprüche 1 bis 3,
    **dadurch gekennzeichnet,**
    **dass** ein Vertikalofensystem mit zumindest 5 Temperaturzonen eingesetzt wird.

5.  Verfahren nach Anspruch 4,
    **dadurch gekennzeichnet,**
    **dass** während der Abscheidung der Borschicht die Temperatur der oberen Zone auf 860°C ± 5°C und die Temperatur der weiteren 4 Zonen (5b-e) zum unteren Ende des Reaktionsraumes (2) hin auf 845°C ± 5°C, 860°C ± 5°C, 890°C ± 5°C und 900°C ± 5°C eingestellt werden,
    und **dass** während der Diffusion die Temperatur der oberen Zone auf 1042°C ± 0,5°C und die Temperatur der weiteren 4 Zonen (5b-e) zum unteren Ende des Reaktionsraumes (2) hin auf 1037°C ± 0,5°C, 1035°C ± 0,5°C, 1027,5°C ± 0,5°C und 1025°C ± 0,5°C eingestellt werden.

6.  Verfahren nach einem der Ansprüche 1 bis 5,
    **dadurch gekennzeichnet,**

**dass** das borhaltige Reaktivgas durch einen BBr$_3$-Bubbler bereitgestellt wird.

7. Verfahren nach einem der Ansprüche 1 bis 6,
   **dadurch gekennzeichnet,**
   **dass** sich das borhaltige Reaktivgas aus Sauerstoff und BBr$_3$ zusammensetzt, das mit Stickstoff als Transportgas in den Reaktionsraum (2) geleitet wird, wobei bei einem Volumen des Reaktionsraumes (2) von 45 bis 55 Liter ein Gasfluss von 10 slm ± 0,5 slm für das Transportgas, von 0,1 slm ± 0,01 slm für den Sauerstoff und von 0,1 slm ± 0,01 slm für das BBr$_3$ eingestellt wird.

**Claims**

1. Method of wafer boron-doping, using a vertical-oven system (1) comprising a reaction chamber (2) extending vertically from an upper end to a lower end and comprising several temperature zones (5a - 5e) heatable independently of each other, whereof an upper zone (5a) is provided on a gas intake (6) for a boron-containing reactive gas while the further zones (5b - 5e) join down to the lower end of said reaction chamber,
   wherein said boron-containing reactive gas is passed over wafers (4) positioned inside said reaction chamber in order to deposit a boron layer on said wafers (4), and wherein subsequently boron penetrates by diffusion from said boron layer into the surface of said wafers (4),
   wherein the temperature of said further zones (5b - 5e) is so adjusted that during the process of depositing said boron layer a temperature increase is maintained across said further zones and during the diffusion process a temperature drop is maintained across said further zones toward the lower end of said reaction chamber (2).

2. Method according to Claim 1,
   **characterised in**
   **that** the temperature of said further zones (5b - 5e) is selected from the temperature range between 800 °C and 950 °C during the process of depositing said boron layer and from the temperature range between 1020 °C and 1050 °C during the diffusion process.

3. Method according to Claim 1 or 2,
   **characterised in**
   **that** during both the depositing process and the diffusion process, a temperature is adjusted in said upper zone (5a), which is higher than in the joining zone (5b) among said further zones.

4. Method according to any of the Claims 1 to 3,
   **characterised in**
   **that** a vertical-oven system with at least 5 temperature zones is used.

5. Method according to Claim 4,
   **characterised in**
   **that** during the process of depositing said boron layer, the temperature of said upper zone is set to 860 °C ± 5 °C, and the temperature of said further 4 zones (5b - 5e) toward said lower end of said reaction chamber (2) is set to 845 °C ± 5 °C, 860 °C ± 5 °C, 890 °C ± 5 °C and 900 °C ± 5 °C,
   and **that** during the diffusion process, the temperature of said upper zone is set to 1042 °C ± 0.5 °C, while the temperature of said further 4 zones (5b - 5e) toward the lower end of said reaction chamber (2) is set to 1037 °C ± 0.5 °C, 1035 °C ± 0.5 °C, 1027.5 °C ± 0.5 °C and 1025 °C ± 0.5 °C.

6. Method according to any of the Claims 1 to 5,
   **characterised in**
   **that** said boron-containing reactive gas is provided by a BBR$_3$ bubbler.

7. Method according to any of the Claims 1 to 6,
   **characterised in**
   **that** said boron-containing reactive gas is composed of oxygen and BBr$_3$, which is fed into said reaction chamber (2) together with nitrogen as carrier gas, with a gas flow rate of 10 slm ± 0.5 slm being set for said carrier gas, of 0.1 slm ± 0.01 slm being set for oxygen, and of 0.1 slm ± 0.01 slm being set for BBr$_3$, at a volume of said reaction chamber (2) of 45 to 55 litres.

**Revendications**

1. Procédé de dopage borique de tranches, par emploi d'un système à four vertical (1) comprenant un espace de réaction (2), qui s'étend en sens vertical à partir d'une extrémité supérieure vers une extrémité inférieure et renferme plusieurs zones de température (5a - 5e) chauffables indépendamment l'une de l'autre, dont une zone supérieure (5a) est munie d'un orifice d'admission de gaz (6) pour un gaz réactif contenant du bore, pendant que les autres zones (5b - 5e) se joignent vers 'extrémité inférieure dudit espace de réaction,
dans lequel ledit gaz réactif contenant du bore est passé sur des tranches (4) placées à l'intérieur dudit espace de réaction pour le dépôt d'une couche en bore sur lesdites tranches (4), et dans lequel du bore pénètre ensuite, par diffusion, de ladite couche en bore dans la surface desdites tranches (4),
dans lequel la température desdites autres zones (5b - 5e) est réglée d'une telle façon, qu'au cours du processus des dépôt de ladite couche en bore, une montée de la température soit maintenue à travers lesdites autres zones, et qu'au cours du processus des diffusion, une réduction de la température soit maintenue à travers lesdites autres zones vers l'extrémité inférieure dudit espace de réaction (2).

2. Procédé selon la revendication 1,
**caractérisé en ce**
**que** la température desdites autres zones (5b - 5e) est choisie dans la gamme de températures entre 800 °C et 950 °C au cours du processus de dépôt de ladite couche en bore, et dans la gamme entre 1020 °C et 1050 °C au cours du processus de diffusion.

3. Procédé selon la revendication 1 ou 2,
**caractérisé en ce**
**qu'**au cours du processus de dépôt ainsi qu'au cours du processus de diffusion, une température est réglée dans ladite zone supérieure (5a), qui est plus haute que la température dans la zone adjacente (5b) parmi lesdites autres zones.

4. Procédé selon une quelconque des revendications 1 à 3,
**caractérisé en ce**
**qu'**un système à four vertical à au moins 5 zones de température est employé.

5. Procédé selon la revendication 4,
**caractérisé en ce**
**qu'**au cours du processus de dépôt de ladite couche en bore, la température dans ladite zone supérieure est réglée à 860 °C ± 5 °C,
et la température dans lesdites autres 4 zones (5b - 5e) vers ladite extrémité inférieure dudit espace de réaction (2) est réglée à 845 °C ± 5 °C, 860 °C ± 5 °C, 890 °C ± 5 °C et 900 °C ± 5 °C,
et en ce qu'au cours du processus de diffusion, la température dans ladite zone supérieure est réglée à 1042 °C ± 0.5 °C, pendant que la température dans lesdites autres 4 zones (5b - 5e) vers l'extrémité inférieure dudit espace de réaction (2) est réglée à 1037 °C ± 0.5 °C, 1035 °C ± 0.5 °C, 1027.5 °C ± 0.5 °C et 1025 °C ± 0.5 °C.

6. Procédé selon une quelconque des revendications 1 à 5,
**caractérisé en ce**
**que** ledit gaz réactif contenant du bore est alimenté par une bouteille gazéifiant de $BBr_3$.

7. Procédé selon une quelconque des revendications 1 à 6,
**caractérisé en ce**
**que** ledit gaz réactif contenant du bore est composé de l'oxygène et du $BBr_3$, qui est alimenté dans ledit espace de réaction (2) ensemble avec un gaz vecteur à azote, à un taux de courant de gaz de 10 slm ± 0,5 slm étant réglé pour ledit gaz vecteur, de 0,1 slm ± 0,01 slm étant réglé pour l'oxygène, et de 0,1 slm ± 0,01 slm étant réglé pour le $BBr_3$, à un volume dudit espace de réaction (2) de 45 à 55 litres.

Figur